# EUROPÄISCHE PATENTSCHRIFT

(11) **EP 1 209 481 B1**
(45) Veröffentlichungstag und Bekanntmachung des Hinweises auf die Patenterteilung: **19.07.2006**
(21) Anmeldenummer: 01124683.2
(22) Anmeldetag: 16.10.2001
(51) Int. Cl.: G01R 33/561

(54) **Phasenkorrekturverfahren für die MR-Echtzeitbildgebung**
Method of correcting phase errors in real-time MRI
Procédé de correction d'erreurs de phase dans un procédé d'IRM temps réel

(30) Priorität: 18.10.2000 DE 10051594
(43) Veröffentlichungstag der Anmeldung: 29.05.2002
(73) Patentinhaber: Philips Intellectual Property & Standards GmbH, 20099 Hamburg (DE); Koninklijke Philips Electronics N.V., 5621 BA Eindhoven (NL)
(72) Erfinder: Schäffter, Tobias, c/o Philips Corporate, 52064 Aachen (DE); Koken, Peter, c/o Philips Corporate, 52064 Aachen (DE)
(74) Vertreter: Volmer, Georg

(56) Entgegenhaltungen:
- EP-A- 0 909 958
- US-A- 5 942 897
- US-A- 6 057 686

## Beschreibung

Die Erfindung betrifft ein MR-Bildgebungsverfahren gemäß dem Oberbegriff des Anspruchs 1. Die Erfindung betrifft des weiteren ein MR-Gerät zur Durchführung des Verfahrens und ferner ein Computerprogramm zur Steuerung des MR-Gerätes.

Viele technische Weiterentwicklungen der Hard- und Software von MR-Geräten zielten in den letzten Jahren darauf ab, die Bildaufnahmezeiten drastisch zu verkürzen. Die erreichbare Bildrate ist mittlerweile so hoch, dass die MR-Echtzeitbildgebung für verschiedene medizinische Anwendungszwecke zu einem wichtigen Werkzeug geworden ist. Von besonderem Interesse ist die MR-Echtzeitbildgebung für die Diagnose im Bereich der Kardiologie, wie z.B. für die dynamische Untersuchung der Funktion der Herzkranzgefäße und des Herzmuskels. Weitere Anwendungsmöglichkeiten liegen im Bereich der interventionellen Radiologie, wie z.B. für die Überwachung von minimal invasiven Eingriffen, Biopsien usw., die innerhalb eines MR-Tomographen durchgeführt werden. Von den Anwendern dieser Verfahren wird gewünscht, qualitativ hochwertige Bilder mit einer möglichst hohen Bildrate zur Verfügung zu haben, um z.B. die Bewegungen des Herzmuskels oder der interventionellen Instrumente kontinuierlich, d.h. in Echtzeit, beobachten zu können. An einer weiteren Verbesserung und Beschleunigung der Verfahren für die MR-Echtzeitbildgebung besteht entsprechend weiterhin ein großes Interesse.

Bekanntermaßen handelt es sich bei der Kernspintomographie um ein spektrales Bildgebungsverfahren, bei dem durch die Verwendung eines räumlich inhomogenen Magnetfeldes (Magnetfeldgradienten) die Lokalisierung der Kernmagnetisierung anhand der jeweils zugehörigen Resonanzfrequenz erfolgt. Es ist allgemein üblich, zur Bilderzeugung das Kernspinsignal als Spannung, die in einer den Untersuchungsbereich umgebenen Spule induziert wird, unter dem Einfluß einer geeigneten Abfolge (Sequenz) von Hochfrequenz- und Gradientenpulsen in der Zeitdomäne aufzuzeichnen. Die eigentliche Bildrekonstruktion erfolgt dann durch Fouriertransformation der Zeitsignale. Durch die Zahl, den zeitlichen Abstand, die Dauer und die Stärke der verwendeten Gradienten- und Hochfrequenzpulse ist die Abtastung des reziproken sogenannten "k-Raumes" vorgegeben, durch den der abzubildende Volumenbereich sowie die Bildauflösung bestimmt sind. Entsprechend wird durch die Anforderungen an die Bildgröße und die Bildauflösung die benötigte Zahl von Phasenkodierungsschritten und damit die Dauer der Bildgebungssequenz vorgegeben. Eine allgemein übliche Pulssequenz zur sequentiellen Abtastung des k-Raumes, die eine überaus schnelle Bildgebung gestattet und die deswegen für die MR-Echtzeitbildgebung besonders wichtig ist, ist die EPI-Sequenz (echo planar imaging). Mittels einer derartigen Bildgebungs-Pulssequenz wird eine zweidimensionale Abbildung einer ausgewählten Schicht im Untersuchungsvolumen erzeugt.

Aus der US 5 942 897 ist bereits ein MR-Bildgebungsverfahren bekannt, bei dem mindestens eine Kalibrierungs-Pulssequenz erzeugt wird, für deren mit gleicher Phasenkodierung und entgegengesetzt gleichem Auslesegradienten aufgenommene MR-Daten die Phasendifferenzen ermittelt und als Phasenkorrekturprofil zur Phasenkorrektur von unter wiederholter Einstrahlung von Bildgebungs-Pulssequenzen aufgenommenen MR-Daten herangezogen werden. Wenn sich das Wirbelstromverhalten des MR-Gerätes nach der Kalibrierungs-Pulssequenz aber ändert, verliert die Phasenkorrektur ihre Wirkung. Das soll bei einer Variante des Verfahrens vermieden werden, bei der die zur Phasenkorrektur herangezogene Phasendifferenz fortlaufend aus mit entgegengesetztem zeitlichen Verlauf aufeinander folgenden Bildgebungs-Pulssequenzen abgeleitet wird. Abgesehen davon, dass es bei diesem Verfahren zu Bildartefakten kommen kann, wenn das Wirbelstromverhalten sich innerhalb einer Bildgebungs-Pulssequenz merklich ändert, verursacht die damit verbundene u. U. ständig variierende Phasenkorrektur bei der Echtzeitbildgebung einen störenden, unruhigen Bildeindruck.

Ein weiteres MR-Bildgebungsverfahren ist in der US 5 621 321 beschrieben. Dabei werden die MR-Datensätze, die mittels einer geeigneten Bildgebungs-Pulssequenz gewonnen werden, einer Phasenkorrektur unterzogen, um Phasenfehler zu kompensieren, die ansonsten zu unerwünschten Bildartefakten führen würden. Es ist ein allgemein bekanntes Phänomen, dass die MR-Signale zunächst noch mit Phasenfehlern behaftet sind, die zum Teil durch Wirbelströme (sog. eddy currents) verursacht werden, die in der Umgebung des Untersuchungsbereiches durch die zeitlich rasch variierenden Magnetfelder der Bildgebungs-Pulssequenzen induziert werden. Bei dem vorbekannten Verfahren wird mittels einer Kalibrierungs-Pulssequenz ein Phasenkorrekturprofil bestimmt, welches dann dazu genutzt wird, die in den eigentlichen MR-Bilddaten vorhandenen Phasenfehler auszugleichen. Das Phasenkorrekturprofil ist dabei ein Satz von komplexen Phasenfaktoren, welche eine lineare und nichtlineare Phasenkorrektur des gesamten MR-Signals ermöglichen.

Das Wirbelstromverhalten, das einen entscheidenden Einfluß auf die Phasenfehler der MR-Signale hat, hängt empfindlich von der Richtung, der Zahl und der Stärke der verwendeten Gradientenpulse und auch von der relativen Position des Untersuchungsobjektes innerhalb der MR-Anordnung ab. Daraus ergibt sich, dass sich die Phasenfehler ändern, sobald beispielsweise die Lage und die Ausrichtung der Bildebene modifiziert wird, oder sobald das Untersuchungsobjekt seine Position verändert. Dementsprechend hängt auch das Phasenkorrekturprofil stark von der selektierten Bildebene ab und muß gemäß dem vorbekannten Verfahren erneut mittels der Kalibrierungspulssequenz vermessen werden, sobald die Lage der Bildebene verändert wird oder sobald der Patient im MR-Gerät seine Position verändert. Hinzu kommen langsame Veränderungen im Wirbelstromverhalten, die durch thermische Einflüsse auf die MR-Apparatur bedingt sind und die ebenfalls eine Aktualisierung der Phasenkorrekturprofile nötig machen.

Viele Anwendungen der MR-Echtzeitbildgebung machen es erforderlich, die Lage der Bildebene interaktiv während der fortlaufenden Bildgebung anzupassen, um bestimmte Bewegungsabläufe, beispielsweise von interventionellen Instrumenten, optimal und kontinuierlich verfolgen zu können. Nach dem vorbekannten MR-Bildgebungsverfahren wäre es in diesem Fall nötig, permanent die Phasenkorrekturprofile mittels der Kalibrierungs-Pulssequenz neu zu vermessen, was zu einer unerwünschten Verzögerung der Bilddarstellung führt, da ein wesentlicher Teil der gesamten Meßzeit für die Ermittlung der Phasenkorrekturprofile verbraucht wird.

Das Wirbelstromverhalten einer MR-Anordung ist äußerst komplex und nur schwer vorhersagbar. Von daher besteht die Möglichkeit, dass gewisse Änderungen in der Lage der Bildebene nur geringe Veränderungen der Phasenfehler bewirken. In diesem Falle ist die erneute Messung der Phasenkorrekturprofile bei jeder Variation der Bildebene unter Umständen eine unnötige Verschwendung wertvoller Meßzeit.

Der vorliegenden Erfindung liegt dementsprechend die Aufgabe zugrunde, ein verbessertes MR-Bildgebungsverfahren bereitzustellen, bei dem die Bildrate gegenüber den vorbekannten Verfahren dadurch weiter gesteigert wird, dass die Meßzeit, die auf die Bestimmung der Phasenkorrekturprofile zu verwenden ist, soweit wie möglich reduziert wird.

Diese Aufgabe wird bei einem MR-Bildgebungsverfahren der eingangs genannten Art dadurch gelöst, dass die Phasenfehler kontinuierlich überwacht werden und dass eine weitere Kalibrierungs-Pulssequenz initiiert wird, wenn die Phasendifferenzen von MR-Daten aus der Kalibrierungs-Pulssequenz einerseits und der Bildgebungs-Pulssequenzen andererseits, die mit gleicher Phasenkodierung und entgegengesetzt gleichem Auslesegradienten zeitlich aufeinanderfolgend aufgenommen wurden, gegenüber den zur Phasenkorrektur herangezogenen Phasendifferenzen eine signifikante Veränderung aufweisen,
und dass die weitere Kalibrierungssequenz zur Phasenkorrektur und zur Überwachung nachfolgender Bildgebungs-Pulssequenzen herangezogen wird.

Der Erfindung liegt die Idee zugrunde, die für die Bilderzeugung aufgenommenen MR-Datensätze dazu zu nutzen, das Verhalten der Phasenfehler kontinuierlich zu überwachen, ohne dass dafür eigens immer wieder Phasenkorrekturprofile mittels Kalibrierungsmessungen zeitaufwendig bestimmt werden müssen. Veränderungen im Wirbelstromverhalten, die durch Veränderung der Bildebene, Bewegungen des Untersuchungsobjektes oder durch thermische Drift verursacht werden, können fortlaufend anhand der Veränderungen der Phasendifferenzen bestimmt werden.

Die Phasendifferenzen beziehen sich erfindungsgemäß auf MR-Daten, die mit gleicher Phasenkodierung und mit entgegengesetzt gleichem Auslesegradienten aufgenommen wurden. Diese Phasendifferenzen beruhen im wesentlichen auf den Einflüssen der Wirbelströme, so dass eine kontinuierliche Überwachung von Veränderungen im Wirbelstromverhalten anhand dieser Phasendifferenzen erfolgen kann. Die zur Phasenkorrektur benutzten Phasendifferenzen werden dabei aus der Kalibrierungssequenz selbst abgeleitet, während die Überwachung auch auf Phasendifferenzen basiert, die sich auf MR-Daten aus der Kalibrierungs-Pulssequenz einerseits und aus der Bildgebungs-Pulssequenzen andererseits beziehen.

Sobald erfindungsgemäß eine signifikante Veränderung der Phasendifferenzen registriert wird, wird eine Kalibrierungs-Pulssequenz initiiert, die zur Phasenkorrektur und zur Überwachung nachfolgender Bildgebungs-Pulssequenzen herangezogen wird. Gegenüber dem vorbekannten MR-Bildgebungsverfahren hat dies den Vorteil, dass nur dann automatisch eine Kalibrierungsmessung durchgeführt wird, wenn es wirklich nötig ist, wenn sich nämlich das Wirbelstromverhalten so stark geändert hat, dass die jeweils verwendete Phasenkorrektur nicht mehr wiksam ist. Auf diese Weise wird die für die Phasenkorrektur durch die zusätzliche Kalibrierungs-Pulssequenz erforderliche Meßzeit auf ein Mindestmaß beschränkt. Bei der kontinuierlichen Überwachung der Phasenfehler gemäß der Erfindung kann eine statistische Analyse der ermittelten Phasendifferenz-Profile erfolgen, für die ein Schwellenwert vorgebbar ist, anhand dessen dann die Signifikanz der Änderungen im Wirbelstromverhalten bewertet wird.

Bei dem MR-Bildgebungsverfahren gemäß der Erfindung ist es vorteilhaft, das Vorzeichen der Auslesegradienten bei den aufeinanderfolgend eingestrahlten Bildgebungs-Pulssequenzen zu wechseln. Auf diese Weise werden nämlich MR-Signale, wie etwa einzelne Echosignale einer EPI-Sequenz, mit gleicher Phasenkodierung jeweils abwechselnd mit entgegengesetzten Auslesegradienten aufgenommen.

Für die MR-Echtzeitbildung kann es zweckmäßig sein, Bildgebungs-Pulssequenzen mit verschachtelten Phasenkodierungsschritten zu verwenden (sog. sliding window reconstruction). Dies hat unter anderem den Vorteil, dass während einer einzigen vollständigen k-Raum Abtastung eine mehrfache Bildrekonstruktion erfolgen kann, was zu einer Erhöhung der Bildrate führt (vgl. S. Riederer et al., Magnetic Resonance in Medicine, Bd. 8, Seiten 1-15, 1988). Sollen bei einem solchen Bildgebungsverfahren die Phasenfehler erfindungsgemäß überwacht werden, so werden zweckmäßigerweise nach jeder vollständigen k-Raum Abtastung die Vorzeichen der Auslesegradienten gewechselt. Dies hat den Vorteil, dass die Phasendifferenzen aufeinanderfolgend aufgenommener MR-Signale mit jeweils gleicher Phasenkodierung bei entgegengesetzt gleichen Auslesegradienten, wie oben beschrieben, zur Überwachung der Phasenfehler oder zur Ermittlung von Phasenkorrekturprofilen zueinander in Beziehung gesetzt werden können.

Für die MR-Echtzeitbildgebung eignen sich in besonderer Weise Bildgebungs-Pulssequenzen wie die oben bereits erwähnte EPI (echo planar imaging) oder die EVI (echo voluminar imaging) Sequenzen. Mit diesen ultraschnellen Bildgebungssequenzen, bei denen der Auslesegradient zur Erzeugung von Gradientenchos kontinuierlich hin- und hergeschaltet wird, kann ein komplettes Bild mit nur einer einzigen Hochfrequenzanregung erzeugt werden. Die Aufnahmezeiten für ein Einzelbild liegen dabei ohne weiteres deutlich unterhalb von 100 Millisekunden.

Die Ausgestaltung nach Anspruch 5 erlaubt eine häufigere Überprüfung des Wirbelstromverhaltens. Dabei werden auch MR-Daten herangezogen, die mit einer von Null verschiedenen Phasenkodierung aufgenommen wurden. Dies hat zu Folge, dass das Rauschen bei der Aufnahme der Signale sich stärker bemerkbar macht. Das kann aber zumindest für Überwachungszwecke akzeptiert werden.

Zur Durchführung des MR-Bildgebungsverfahrens gemäß der Erfindung eignet sich ein MR-Gerät nach Anspruch 6. Das erfindungsgemäße Verfahren läßt sich also ohne weiteres auf einem üblichen, im klinischen Einsatz befindlichen MR-Tomographen implementieren, ohne dass irgendwelche Anpassungen der Hardware nötig werden. Erforderlich ist lediglich eine Anpassung der Programmierung der Rekonstruktionseinheit.

Dies kann mittels eines Computerprogrammes nach Anspruch 7 zur Steuerung des MR-Gerätes erfolgen. Ein solches Computerprogramm kann insbesondere anhand der ermittelten Phasendifferenzen direkt eine Phasenkorrektur der MR-Daten vornehmen. Das Programm muß hierzu mit der Steuerungseinheit kommunizieren, um die korrekte Zuordnung der MR-Signale, anhand derer, wie oben beschrieben, die Phasenfehler überwacht werden können, vornehmen zu können. Ein derartiges Computerprogramm kann den Anwendern von MR-Geräten vorteilhafterweise auf einem geeigneten Datenträger, wie einer Diskette oder einer CD-ROM, oder zum Herunterladen über ein Datennetz zur Verfügung gestellt werden.

Ausführungsbeispiele der Erfindung werden im folgenden anhand der Figuren erläutert.
Es zeigen:
- Figur 1: Abfolge von EPI-Sequenzen mit Überwachung des Phasenfehlers gemäß der Erfindung und mit Kalibrierungsmessung ohne Phasenkodierung;
- Figur 2: Abfolge von EPI-Sequenzen mit Überwachung des Phasenfehlers und mit Kalibrierungsmessung mit Phasenkodierung;
- Figur 3: Schematischer Ablauf einer erfindungsgemäßen MR-Bildgebung mit automatischer Überwachung der Phasenfehler;
- Figur 4: MR-Gerät gemäß der Erfindung;

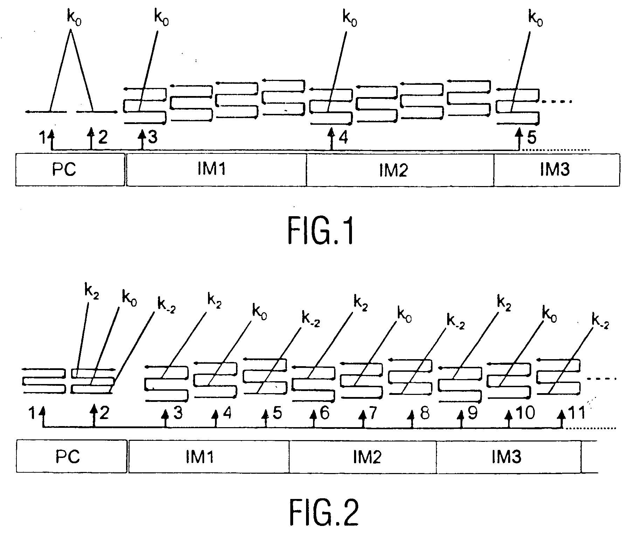

In Figur 1 ist der Ablauf einer MR-Bildgebung gemäß der Erfindung schematisch dargestellt. Das Schema beginnt mit einer kurzen Kalibrierungssequenz PC, in welcher zwei MR-Signale 1 und 2 mit gleicher Phasenkodierung k₀ mit jeweils entgegengesetzt gleichem Auslegradienten aufgenommen werden. Durch den Verlauf der in der Figur abgebildeten Pfeile wird die Abtastung des zweidimensionalen k-Raumes verdeutlicht. Die Pfeilrichtung deutet das Vorzeichen des jeweiligen Auslesegradienten an. Aus der Phasendifferenz zwischen den beiden mittels der Kalibrierungssequenz aufgenommenen MR-Signalen 1 und 2 wird ein Phasenkorrekturprofil ermittelt, welches im folgenden für die Korrektur der Phasenfehler verwendet wird. Dazu werden die beiden Datensätze zunächst Fourier transformiert worauf einer von beiden komplex konjugiert wird. Schließlich wird der komplex konjugierte Datensatz mit dem korrespondierenden Datensatz Punkt für Punkt multipliziert. Am Ende wird das Produkt auf den Betrag 1 normiert. Das Ergebnis dieser Rechenprozedur ist dann das gewünschte Phasenkorrekturprofil, welches für jeden einzelnen Datenpunkt die Phasendifferenz als komplexen Phasenfaktor enthält. An die Kalibrierungssequenz PC schließt sich die eigentliche Bildgebungsphase an. Für die Bildgebung werden wiederholt EPI-Sequenzen mit verschachtelter Phasenkodierung eingestrahlt. Jede vollständige k-Raum Abtastung IM1-IM3 besteht jeweils aus vier EPI-Sequenzen. Eine Bildrekonstruktion wird dabei nach jeder einzelnen EPI-Sequenz durchgeführt, wozu der zugehörige Teil des k-Raumes jeweils im vollständigen Bilddatensatz aktualisiert wird. Die so gewonnenen, zeitlich aufeinanderfolgenden MR-Datensätze 3, 4 und 5 enthalten einzelne Echosignale, die die gleiche Phasenkodierung k₀ aufweisen, wie die MR-Signale 1 und 2 der Kalibrierungssequenz. Der Auslesegradient hat bei den entsprechenden Signalen der Messungen 3, 4 und 5 das entgegengesetzte Vorzeichen wie bei dem Signal 2. Zur Überwachung des Phasenfehlers gemäß der Erfindung können nun die bezeichneten MR-Signale der Messungen 3, 4 und 5 zu dem Signal 2 in Beziehung gesetzt werden. Dies erfolgt, indem Profile der Phasendifferenzen zwischen den Signalen 3 und 2, 4 und 2, 5 und 2 usw. berechnet und mit dem während der Kalibrierungsphase gewonnen Phasenkorrekturprofil verglichen werden. Dazu verwendet man zweckmäßigerweise einen geeigneten statistischen Analysealgorithmus, um zufällige Signalschwankungen berücksichtigen zu können. Bei dieser Variante des MR-Bildgebungsverfahrens gemäß der Erfindung findet also eine Überprüfung der Phasenfehler bei jeder vierten Einzelmessung statt.

Die Figur 2 zeigt den Ablauf einer erfindungsgemäßen MR-Bildgebung, bei der die Kalibrierungssequenz PC mit Phasenkodierung durchgeführt wird. Dies erlaubt gegenüber dem zuletzt beschriebenen Beispiel eine häufigere Überprüfung der Phasenfehler. Während der Kalibrierungssequenz PC erfolgen Messungen mit den Phasenkodierungen k₋₂, k₀ und k₂. Bei der eigentlichen Bildgebung werden wiederum EPI-Sequenzen mit verschachtelter Phasenkodierung verwendet, wobei jede vollständigen k-Raum Abtastung IM1-IM3 aus jeweils drei einzelnen EPI-Sequenzen zusammengesetzt ist. Jede einzelne EPI-Sequenz enthält einen Phasenkodierungsschritt, der zu einem Echosignal der Kalibrierungssequenz korrespondiert. Nach dem oben beschriebenen Verfahren werden zur Überwachung der Phasenfehler die MR-Signale 3 und 2 zueinander in Beziehung gesetzt, wobei die Phasendifferenzen zwischen den Echosignalen mit Phasenkodierung k₂, die mit jeweils entgegengesetzten Auslesegradienten aufgenommenen werden, zu ermitteln sind. Entsprechend werden im weiteren Verlauf die Messungen 4 und 2, 5 und 2 usw. miteinander korreliert. Dabei korrespondieren dann die Signale mit den übrigen Phasenkodierungen k₀, k₋₂ usw. zueinander. Bei dieser Variante werden die Phasenfehler bei jeder einzelnen Messung überwacht. Änderungen im Wirbelstromverhalten können also schneller registriert werden.

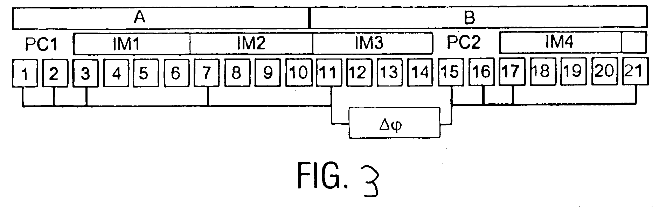

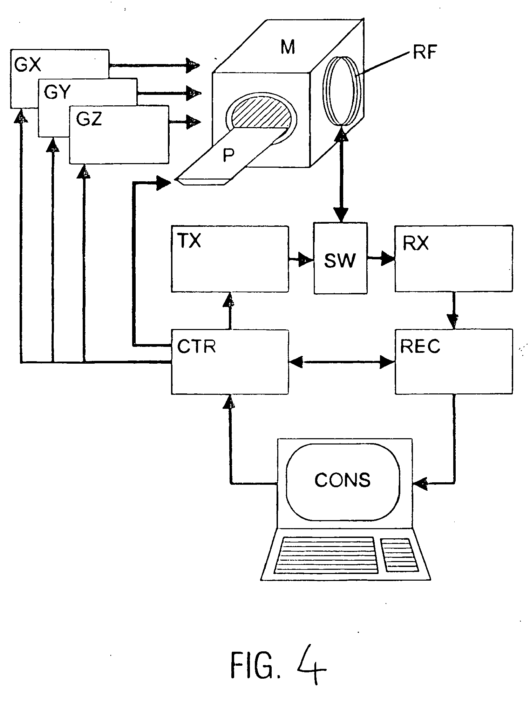

Die Figur 3 veranschaulicht wie das Verfahren gemäß der Erfindung zur fortlaufenden Bildgebung eingesetzt werden kann, wobei automatisch eine neue Kalibrierungsmessung initiiert wird, sobald eine signifikante Änderung der Phasenfehler registriert wird. Die MR-Bildgebung beginnt mit einer ersten Orientierung der Bildebene A, die im Laufe der Untersuchung interaktiv auf eine zweite, unterschiedliche Orientierung B gewechselt wird. Die Bildgebungssequenz beginnt zur ersten Festlegung des Phasenkorrekturprofils mit einer Kalibrierungsmessung PC1, die aus zwei Einzelmessungen 1 und 2 besteht. Daran schließen sich EPI-Sequenzen 3 bis 14 mit verschachtelten Phasenkodierungsschritten an. Eine vollständige k-Raum Abtastung umfaßt jeweils 4 Teilmessungen. Gemäß der Erfindung werden die in der Figur 4 miteinander durch Linien verbunden dargestellten Einzelmessungen zueinander in Beziehung gesetzt, um eine Änderung der Phasenfehler zu registrieren. Bei den ersten drei vollständigen Abtastungen IM1-IM3 wird das zu Beginn mittels der Kalibrierungsmessung PC1 ermittelte Phasenkorrekturprofil zugrundegelegt. Durch die Änderung der Orientierung der Bildebene von A auf B ändert sich das Wirbelstromverhalten, weswegen durch erfindungsgemäße Kombination der Messung 11 mit den Daten der Kalibrierungssequenz PC1 eine Veränderung Δϕ der Phasenfehler registriert wird. Daraufhin wird eine neue Kalibrierung PC2 initiiert, welche zur Kompensation der Phasenfehler im weiteren Verlauf der Bildgebung (IM4, IM5 usw.) ein neues Phasenkorrekturprofil ermittelt.

Die Figur 4 zeigt schematisch ein MR-Gerät, das zur Durchführung des erfindungsgemäßen Verfahrens geeignet ist. Im Zentrum der Apparatur steht ein Hauptmagnet M, der in einem Untersuchungsbereich ein im wesentliches homogenes, stationäres Magnetfeld mit einer Flußdichte von z.B. 1.5 Tesla erzeugt. Bei dem Magneten M handelt es sich üblicherweise um einen supraleitenden Elektromagneten. In den Magneten M einfahrbar ist ein Patiententisch P, auf dem sich bei einer Untersuchung ein Patient befindet. Die Feldrichtung des Magneten M verläuft typischerweise parallel zur Längsrichtung des Patiententisches P. Des weiteren ist eine Anordnung von Gradientenspulen GX, GY, GZ vorgesehen, die über nicht näher dargestellte Gradientenverstärker mit Strom versorgt werden. Damit lassen sich im Untersuchungsbereich die für die verschiedenen Pulssequenzen benötigten Gradientenpulse in beliebigen Raumrichtungen erzeugen. Eine Hochfrequenzspulen-Anordnung RF dient dazu, Hochfrequenzpulse in den Untersuchungsbereich einzustrahlen und MR-Signale aus dem Untersuchungsbereich zu empfangen. Hierzu ist die Spulenanordnung RF über einen Schalter SW zwischen einem Hochfrequenz-Leistungssender TX und einem Empfänger RX hin- und herschaltbar. Der Sender TX wird von einer Steuereinheit CTR angesteuert, welche zur Erzeugung der benötigten Pulssequenzen auch die Gradientenspulen GX, GY und GZ kontrolliert. Außerdem wird über die Steuereinheit CTR die Position des Patiententisches P variiert. Eine Rekonstruktionseinheit REC digitallsiert und speichert die vom Empfänger RX übermittelten MR-Signale, führt eine Phasenkorrektur auf der Grundlage von ebenfalls in der Rekonstruktionseinheit gespeicherten Phasenkorrekturprofilen aus und rekonstruiert dann daraus durch zwei- oder dreidimensionale Fouriertransformation Bilder des Untersuchungsbereiches. Die Rekonstruktionseinheit REC steht mit einer Bedienungskonsole CONS in Verbindung, die über einen Monitor verfügt, auf dem die rekonstruierten Bilddaten dargestellt werden. Die Konsole CONS dient gleichzeitig dazu, die gesamte Apparatur zu bedienen und die gewünschten Pulssequenzen zu initiieren. Hierzu steht die Konsole CONS außerdem mit der Steuereinheit CTRL in Verbindung.

Das erfindungsgemäße MR-Bildgebungsverfahren wird durch entsprechende Programmierung der Rekonstruktionseinheit REC implementiert. Die dort gespeicherten MR-Datensätze werden zur Überwachung der Phasenfehler, wie oben beschrieben, zueinander in Beziehung gesetzt und die so ermittelten Phasendifferenzen werden einer statistischen Analyse unterzogen, wobei die zeitliche Veränderung der Wirbelströme bewertet wird. Die Rekonstruktionseinheit kommuniziert mit der Steuereinheit CTR, um einerseits die einzelnen MR-Signale korrekt zuordnen zu können und um andererseits, falls nötig, Kalibrierungsmessungen auszulösen, sobald erfindungsgemäß eine signifikante Änderung der Phasenfehler durch das Programm der Rekonstruktionseinheit REC registriert wird.

## Patentansprüche

1. MR-Bildgebungsverfahren, insbesondere für die Echtzeit-Bildgebung, bei dem mindestens eine Kalibrierungs-Pulssequenz (PC1) erzeugt wird, für deren zeitlich aufeinanderfolgend und mit gleicher Phasenkodierung (k₀) und entgegengesetzt gleichem Auslesegradienten aufgenommenen MR-Daten (1, 2) die Phasendifferenzen ermittelt und zur Phasenkorrektur von unter wiederholter Einstrahlung von Bildgebungs-Pulssequenzen aufgenommenen MR-Daten (3, 4, 5...) herangezogen werden,
**dadurch gekennzeichnet,**
**daß** die Phasenfehler kontinuierlich überwacht werden und dass eine weitere Kalibrierungs-Pulssequenz (PC2) initiiert wird, wenn die Phasendifferenzen von MR-Daten aus der Kalibrierungs-Pulssequenz (2) einerseits und aus den Bildgebungs-Pulssequenzen (z.B. 3) andererseits, die mit gleicher Phasenkodierung (k₀) und entgegengesetzt gleichem Auslesegradienten zeitlich aufeinanderfolgend aufgenommen wurden, gegenüber den zur Phasenkorrektur herangezogenen Phasendifferenzen eine signifikante Veränderung aufweisen,
und **daß** die weitere Kalibrierungssequenz zur Phasenkorrektur und zur Überwachung nachfolgender Bildgebungs-Pulssequenzen herangezogen wird.

2. Verfahren nach Anspruch 1,
**dadurch gekennzeichnet,**
**dass** das Vorzeichen der Auslesegradienten bei den aufeinanderfolgend eingestrahlten Bildgebungs-Pulssequenzen gewechselt wird.

3. Verfahren nach Anspruch 1,
**dadurch gekennzeichnet,**
**dass** aufeinanderfolgende Bildgebungs-Pulssequenzen mit verschachtelten Phasenkodierungsschritten verwendet werden.

4. Verfahren nach Anspruch 1,
**dadurch gekennzeichnet,**
**dass** es sich sich bei den Bildgebungs-Pulssequenzen um EPI (echo planar imaging) oder um EVI (echo voluminar imaging) Sequenzen handelt.

5. Verfahren nach Anspruch 1,
**dadurch gekennzeichnet,**
**dass** die Kalibrierungs-Pulssequenz (PC) mehr als einen Phasenkodierungsschritt (k₀, k₂. k₂) umfaßt.

6. MR-Gerät zur Durchführung des Verfahrens nach Anspruch 1, mit einer Gradientenspulen-Anordnung (GX, GY, GZ) zur Erzeugung von Magnetfeldgradienten, einer Hochfrequenzspulen-Anordnung (RF) zur Erzeugung von Hochfrequenzpulsen und zum Empfang von MR-Signalen, einer Steuereinheit (CTR), durch welche die Gradienten- und Hochfrequenzspulen zur Einstrahlung wenigstens einer Kalibrierungs-Pulssequenz und von Bildgebungs-Pulssequenzen in einen Untersuchungsbereich angesteuert werden, und mit einer Rekonstruktionseinheit (REC), mittels welcher MR-Daten gespeichert und zur Kompensierung von Phasenfehlern einer Phasenkorrektur unterzogen werden,
**dadurch gekennzeichnet,**
**dass** die Rekonstruktionseinheit (REC) derart programmiert ist, daß die Phasenfehler kontinuierlich überwacht werden und dass eine weitere Kalibrierungs-Pulssequenz (PC2) initiiert wird, wenn die Phasendifferenzen von MR-Daten aus der Kalibrierungs-Pulssequenz (2) einerseits und aus den Bildgebungs-Pulssequenzen (z.B. 3) andererseits, die mit gleicher Phasenkodierung und entgegengesetzt gleichem Auslesegradienten zeitlich aufeinanderfolgend aufgenommen wurden, gegenüber den zur Phasenkorrektur herangezogenen Phasendifferenzen eine signifikante Veränderung aufweisen,
und **daß** die weitere Kalibrierungssequenz zur Phasenkorrektur und zur Überwachung nachfolgender Bildgebungs-Pulssequenzen herangezogen wird.

7. Computerprogramm zur Steuerung eines MR-Gerätes nach Anspruch 6,
**dadurch gekennzeichnet,**
**daß** die Phasenfehler kontinuierlich überwacht werden und dass eine weitere Kalibrierungs-Pulssequenz (PC2) initiiert wird, wenn die Phasendifferenzen von MR-Daten aus der Kalibrierungs-Pulssequenz (2) einerseits und aus den Bildgebungs-Pulssequenzen (z.B. 3) andererseits, die mit gleicher Phasenkodierung und entgegengesetzt gleichem Auslesegradienten zeitlich aufeinanderfolgend aufgenommen wurden, gegenüber den zur Phasenkorrektur herangezogenen Phasendifferenzen eine signifikante Veränderung aufweisen,
und **daß** die weitere Kalibrierungssequenz zur Phasenkorrektur und zur Überwachung nachfolgender Bildgebungs-Pulssequenzen herangezogen wird.

## Claims

1. An MR imaging method, notably for real-time imaging, in which at least one calibration pulse sequence (PC1) is generated for which in a time-consecutive manner the phase differences are determined for MR data (1, 2) acquired with the same phase encoding (kₒ) and opposed, equal reading gradient and are used for the phase correction of MR data (3, 4, 5) acquired by means of repeated application of imaging pulse sequences, **characterized in that** the phase errors are continuously monitored and that a further calibration pulse sequence (PC2) is initiated when the phase differences of MR data from the calibration pulse sequence (2), on the one hand, and the imaging pulse sequences (e.g. 3) on the other, which were acquired with the same phase encoding (k₀) and opposed, equal reading gradient in a time-consecutive manner, as opposed to the phase differences used for the phase correction, show a significant change, and that the further calibration sequence is used for the phase correction and for monitoring subsequent imaging pulse sequences.

2. A method as claimed in claim 1, **characterized in that** the sign of the read-out gradients is changed for the successively applied imaging pulse sequences.

3. A method as claimed in claim 1, **characterized in that** use is made of successive imaging pulse sequences with interleaved phase encoding steps.

4. A method as claimed in claim 1, **characterized in that** the imaging pulse sequences are EPI (Echo Planar Imaging) or EVI (Echo Voluminar Imaging) sequences.

5. A method as claimed in claim 1, **characterized in that** the calibration pulse sequence (PC) comprises more than one phase encoding step (k₀, k₂, k₋₂).

6. An MR apparatus for carrying out the method as claimed in claim 1, which apparatus includes a gradient coil system (GX, GY, GZ) for generating magnetic field gradients, an RF coil system (RF) for generating RF pulses and for receiving MR signals, a control unit (CTR) which controls the gradient coils and the RF coils so as to apply at least one calibration pulse sequence and imaging pulse sequences to an examination zone, and includes a reconstruction unit (REC) which stores MR data which is subjected to a phase correction in order to compensate phase errors, **characterized in that** the reconstruction unit (REC) is programmed in such a manner that the phase errors are continuously monitored and that a further calibration pulse sequence (PC2) is initiated when the phase differences of MR data from the calibration pulse sequence (2), on the one hand, and the imaging pulse sequences (e.g. 3) on the other, which were acquired with the same phase encoding and opposed, equal reading gradient in a time-consecutive manner, as opposed to the phase differences used for the phase correction, show a significant change, and that the further calibration sequence is used for the phase correction and for monitoring subsequent imaging pulse sequences.

7. A computer program for controlling an MR apparatus as claimed in claim 6, **characterized in that** the phase errors are continuously monitored and that a further calibration pulse sequence (PC2) is initiated when the phase differences of MR data from the calibration pulse sequence (2), on the one hand, and the imaging pulse sequences (e.g. 3) on the other, which were acquired with the same phase encoding and opposed, equal reading gradient in a time-consecutive manner, as opposed to the phase differences used for the phase correction, show a significant change, and that the further calibration sequence is used for the phase correction and for monitoring subsequent imaging pulse sequences.

## Revendications

1. Procédé d'imagerie RM, en particulier pour l'imagerie en temps réel, dans lequel est produite au moins une séquence d'impulsions de calibrage (PC1) pour laquelle les différences de phase sont déterminées pour les données RM (1,2) successives dans le temps et enregistrées avec le même codage de phase (k0) et un gradient de lecture identique mais opposé et sont utilisées pour la correction de phase de données RM (3, 4, 5, ...) enregistrées moyennant rayonnement répété de séquences d'impulsions d'imagerie,
**caractérisé en ce**
**que** les erreurs de phase sont contrôlées en continu et qu'une séquence d'impulsions de calibrage (PC2) supplémentaire est initiée lorsque les différences de phase de données RM issues de la séquence d'impulsions de calibrage (2), d'une part, et des séquences d'impulsions d'imagerie (p. ex., 3), d'autre part, qui ont été enregistrées successivement dans le temps avec le même codage de phase (k0) et le même gradient de lecture opposé présentent une variation significative par rapport aux différences de phases utilisées pour la correction de phase,
et **que** l'autre séquence de calibrage est utilisée pour la correction de phase et pour le contrôle de séquences d'impulsions d'imagerie suivantes.

2. Procédé selon la revendication 1,
**caractérisé en ce**
**que** le signe des gradients de lecture est changé lors des séquences d'impulsion d'imagerie successivement irradiées.

3. Procédé selon la revendication 1,
**caractérisé en ce**
**que** des séquences d'impulsions d'imagerie successives sont utilisées avec des étapes de codage de phase imbriquées.

4. Procédé selon la revendication 1,
**caractérisé en ce**
**que** les séquences d'impulsions d'imagerie sont des séquences EPI (echo planar imaging) ou EVI (echo voluminar imaging).

5. Procédé selon la revendication 1,
**caractérisé en ce**
**que** la séquence d'impulsions (SI) de calibrage comprend plus d'une étape de codage de phase (k₀, k₂.k₂).

6. Appareil RM d'exécution du procédé selon la revendication 1, avec un montage de bobines à gradient (GX, GY, GZ) pour la production de gradients à champ magnétique, un montage de bobines à haute fréquence (RF) pour la production d'impulsions à haute fréquence et pour la réception de signaux RM, une unité de commande (CTR) par laquelle les bobines à gradient et à haute fréquence sont commandés pour le rayonnement d'au moins une séquence d'impulsions de calibrage et de séquences d'impulsions d'imagerie dans une zone d'examen et avec une unité de reconstruction (REC) à l'aide de laquelle les données RM sont enregistrées et soumises à une correction de phase pour la compensation d'erreurs de phases,
**caractérisé en ce**
**que** l'unité de reconstruction (REC) est programmée de telle sorte que les erreurs de phase soient contrôlées en continu et qu'une séquence d'impulsions de calibrage (PC2) supplémentaire soit amorcée lorsque les différences de phase de données RM provenant de la séquence d'impulsions de calibrage (2), d'une part, et provenant des séquences d'impulsions d'imagerie (p. ex., 3), d'autre part, qui ont été enregistrées successivement dans le temps avec le même codage de phase et un même gradient de lecture opposé présentent une modification significative par rapport aux différences de phases utilisées pour la correction de phase et que la séquence de calibrage supplémentaire est utilisée pour la correction de phase et pour le contrôle de séquences d'impulsions d'imagerie successives.

7. Programme informatique pour la commande d'un appareil RM selon la revendication 6,
**caractérisé en ce**
**que** les erreurs de phase sont contrôlées en continu et qu'une séquence d'impulsions de calibrage supplémentaire (PC2) est initiée lorsque les différences de phase de données RM provenant de la séquence d'impulsions de calibrage (2), d'une part, et provenant des séquences d'impulsions d'imagerie (p. ex., 3), d'autre part, qui ont été enregistrées successivement dans le temps avec le même codage de phase et un même gradient de lecture opposé présentent une modification significative par rapport aux différences de phase utilisées pour la correction de phase et que la séquence de calibrage supplémentaire est utilisée pour la correction de phase et pour le contrôle de séquences d'impulsions d'imagerie successives.
